# EUROPEAN PATENT APPLICATION

(11) **EP 2 019 426 A2**
(43) Date of publication of application: **28.01.2009**
(21) Application number: 08156830.5
(22) Date of filing: 23.05.2008
(51) Int. Cl.: H01L 23/473

(54) **Heatsink having an internal plenum**

(30) Priority: 15.06.2007 US 818839
(71) Applicant: Delphi Technologies, Inc., Troy, Michigan 48007 (US)
(72) Inventor: O'Connor, Kurt F., Carmel, IN 46033 (US)
(74) Representative: Denton, Michael John

(57) **Abstract**

A heatsink for conducting heat away from an electric module in thermal contact with the heatsink includes at least a first heatsink member joined to at least a second heatsink member by a weld joint to define a heatsink having an internal plenum. By replacing conventional adhesive and fastening means used for sealing heatsink members together with a welded joint, a more durable and reliable sealed plenum is obtained. In a preferred aspect, the weld joint is created using a friction stir welding technique.

## Description

### Technical Field

This invention relates to cooling of electronic modules that generate a high amount of heat, and more particularly to the use of heatsinks having an internal plenum for circulating a fluid medium to cool an electronic module.

### Background of the Invention

For an electronic module that consumes a high amount of power, and therefore, generates a large amount of heat that must be dissipated to prevent overheating of sensitive components of the electronic module, means are provided to move heat away from the electronic module. In certain cases, it is possible to remove a sufficient amount of heat to prevent damage and/or malfunction of the electronic module by placing a thermally conductive heatsink structure in contact with the electronic module. The heatsink may include cooling fins to increase the surface area available for convective heat transfer from the heatsink to the surrounding air. A fan may also be employed to move air past the cooling fins and further enhance convective heat transfer. However, electronic modules having very high levels of power consumption which generate more heat than can be effectively removed by a solid heatsink and a fan are becoming more common. For these devices more efficient heat transfer means must be employed. Typically, these means take the form of heatsinks which define an internal plenum for distributing and/or circulating a cooling medium, which may be either a liquid or a gas.

Conventional heatsinks having an internal plenum for distributing and/or circulating a cooling medium typically comprise at least two castings that are sealingly mated together to form an internal cavity. The individual castings are generally sealingly attached to one another using an adhesive sealant and mechanical fasteners. These conventional sealing means are subject to latent defects and deterioration that can result in failure of the seal and ultimately failure of the electronic module.

### Summary of the Invention

The invention provides a heatsink having an internal plenum for distributing and/or circulating a cooling medium which employs an improved means for sealingly mating together at least a first heatsink member to at least a second heatsink member, which is less susceptible to latent defect and deterioration.

In accordance with an aspect of the invention, a heatsink for conducting heat away from an electronic module in thermal contact with the heatsink includes at least a first heatsink member joined to at least a second heatsink member by a weld joint. In accordance with a preferred aspect of the invention, the weld joint is generated using a friction stir welding technique.

In accordance with another aspect to the invention, there is provided a process for making a heatsink for conducing heat away from an electronic module in thermal contact with the heatsink. The process includes steps of providing at least a first heatsink member and a second heatsink member that are configured to be joined along mating edges to define a heatsink having an internal plenum, and welding the heatsink members together along the mating edges to form a heatsink having the internal plenum. In accordance with a preferred aspect of the invention, the welding step is achieved using a friction stir welding technique.

In accordance with the disclosed heatsink and method of making same, the weld joint provides a seal along the mating edges of the heatsink members that is extremely durable and reliable.

These and other features, advantages and objects of the present invention will be further understood and appreciated by those skilled in the art by reference to the following specification, claims and appended drawings.

### Brief Description of the Drawings

The present invention will now be described, by way of example, with reference to the accompanying drawings, in which:
FIG. 1 is a cross-sectional view of a heatsink having an internal plenum or cavity for circulating and/or distributing a fluid medium to convectively remove heat from the heatsink.
FIG. 2 is a top plan view of a fluid medium distribution plate located in the heatsink shown in FIG. 1.
FIG. 3 is a perspective view showing the components of the heatsink of FIGs. 1 and 2 prior to assembly.

### Description of the Preferred Embodiments

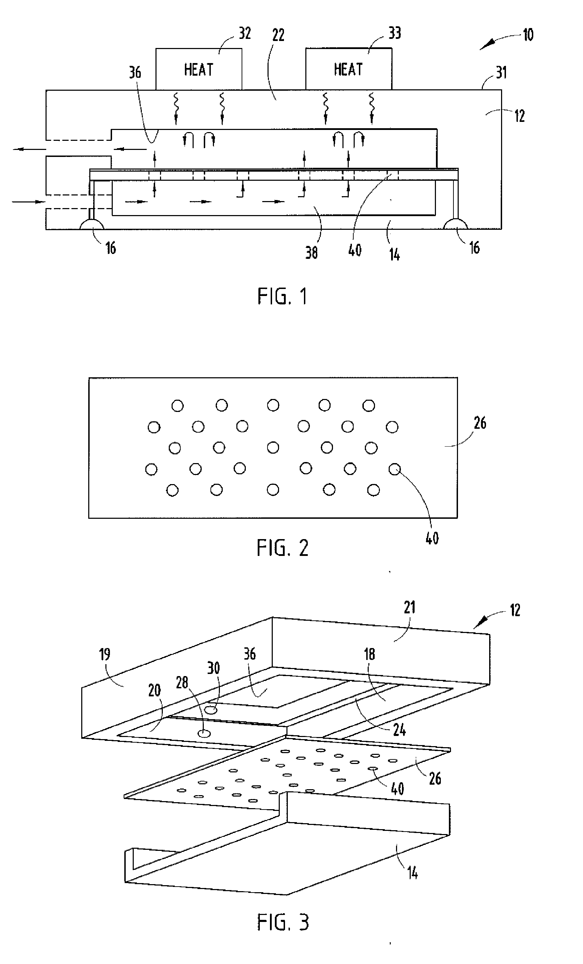

Shown in FIG. 1 is a heatsink 10 in accordance with the invention having a first heatsink member 12 joined to a second heatsink member 14 by a weld joint 16. In the illustrated embodiment, as shown in FIG. 3, the first heatsink member 12 has an open box-like shape or configuration defined by opposite sidewalls 18, 19, opposite end walls 20, 21, and roof 22. Sidewalls 18, 19 and end walls 20, 21 define a ledge or step 24. An optional cooling medium distribution plate 26 is retained between ledge 24 and second heatsink member 14. A cooling medium inlet port 28 and a cooling medium outlet port 30 are defined through end wall 20. Electronic modules 32, 33 are positioned on heatsink 10 in thermal contact with the exterior surface 31 of roof 22. The expression "in thermal contact" as used herein means that heat can be conducted from electronic modules 32, 33 through roof 22 to internal surface 36 of roof 22, either directly or through a material interposed between roof 22 and modules 32, 33, such as a thermally conductive adhesive.

The heat is convectively transferred from heatsink 10 through outlet port 30 by a heat transfer fluid or cooling medium passing through cavity 38 and contacting surface 36. In use, conduits such as pipes or tubing will be connected to the inlet port 28 and outlet port 30 to supply cool medium to the heatsink plenum and to typically return heated heat transfer medium to a radiator where it is cooled for recirculation to the heatsink plenum.

The electrical modules (e.g., 32, 33) can be generally any electrically powered device that generates heat and requires cooling during its operation.

In the illustrated embodiment, optional cooling medium distribution plate 26 is preferably used to redirect the flow of the cooling medium through apertures 40 in a direction generally perpendicular to surface 36 so that the fluid impinges directly against surface 36 to enhance convective heat transfer and reduce or eliminate stagnant pockets of cooling medium within cavity 38. The expression "plenum" as used herein means a cavity defined within the heatsink, or a portion of a cavity defined within a heatsink that is used for distributing flow of the cooling medium along internal surfaces of the heatsink.

The cooling medium may comprise generally any suitable liquid (such as water) or gas (such as air) that may be effectively utilized for convective heat transfer.

Heatsink members 12, 14 are made of a weldable material that has a relatively high thermal conductivity, typically at least 10 watts per meter per degree Kelvin (Wm⁻¹ K⁻¹ ), and more preferably at least 100 watts per meter per degree Kelvin. Suitable materials for heatsink members 12, 14 are weldable metals or metal alloys, more preferably weldable metals or metal alloys that are resistant to corrosion, such as aluminum, aluminum alloys, copper, copper alloys, magnesium, magnesium alloys, and stainless steel. Although various other materials may be utilized, most preferably, heatsink members 12, 14 are comprised of aluminum because of its relatively high thermal conductivity, low cost, and the ease by which it can be cast and/or machined. Cooling medium distribution plate 26 may be fabricated from generally any material having suitable resistance to the selected cooling medium, and may be made of various metals or metal alloys, plastics, glass, or ceramic materials.

In a preferred embodiment, heating members 12, 14 are joined and sealed together by a weld joint 16 that is produced by a friction stir welding technique. In friction stir welding, a tool with a probe attached to its tip is rotated at a high speed while being pushed against abutting sections of the pieces of metal to be welded together. The downward pressure applied to the probe and transferred to the abutting sections of the metal pieces creates friction heat between the probe and the metal causing the metal to become plasticized. The circular movement of the probe mixes the metals from the two pieces (which may be comprised of the same or different metals or alloys) together to form a homogenous bond joint. As the friction stir equipment senses that the material has been plasticized, it progresses along a pre-programmed weld path. Friction stir welding has several advantages over other welding techniques. First, it creates a hermetic seal between the joined pieces, and second, unlike with fusion welding techniques, weld joints produced by friction stir welding techniques have excellent mechanical properties regardless of whether the joined pieces are composed of the same or different metals or metal alloys. The strong and durable weld joint between the heatsink members eliminates the need for adhesives and mechanical fasteners, thereby eliminating the need for adhesive dispensing equipment and equipment or labor needed for mechanical fastening. Friction stir welding also produces a reliable weld joint that is not susceptible to failure, and which provides improved electromagnetic compatibility. In fact, the high reliability of the weld joint produced by friction stir welding is expected to eliminate the need for leak testing after assembly.

The weld joint formed by friction stir welding has a grain structure that is smaller (finer) and a mechanical strength property that is greater than that of a weld joint formed using a thermal welding technique (e.g., MIG, TIG, arc welding, acetylene welding).

Welding of plenum member provides a conductive path for ground and improved resistance to electromagnetic interference.

It will be understood by those who practice the invention and those skilled in the art that various modifications and improvements may be made to the invention without departing from the spirit of the disclosed concept. The scope of protection afforded is to be determined by the claims and by the breadth of interpretation allowed by law.

## Claims

1. A heatsink for conducting heat away from an electronic module, comprising:
at least a first heatsink member joined to at least a second heatsink member by a weld joint to define a heatsink having an internal plenum, the weld joint having a mechanical strength property that is greater than the mechanical strength property of a thermal weld joint; and
at least one electronic module in thermal contact with the heatsink.

2. The heatsink of claim 1, wherein the heatsink members are comprised of a material having a thermal conductivity of at least 10 watts per meter per degree Kelvin.

3. The heatsink of claim 1, wherein the heatsink members are comprised of a material having a thermal conductivity of at least 100 watts per meter per degree Kelvin.

4. The heatsink of claim 1, wherein the heatsink members are comprised of aluminum.

5. The heatsink of claim 1, wherein the heatsink members are aluminum castings.

6. The heatsink of claim 1, wherein the weld joint is produced by friction stir welding.

7. A process for making a heatsink for conducting heat away from an electronic module in thermal contact with the heatsink, comprising:
providing at least a first heatsink member and a second heatsink member that are configured to be joined along mating edges to define a heatsink having an internal plenum; and
welding the heatsink members together along the mating edges to form a heatsink having an internal plenum.

8. The process of claim 7, wherein the heatsink members are comprised of a material having a thermal conductivity of at least 10 watts per meter per degree Kelvin.

9. The process of claim 7, wherein the heatsink members are comprised of a material having a thermal conductivity of at least 100 watts per meter per degree Kelvin.

10. The process of claim 7, wherein the heatsink members are comprised of aluminum.

11. The process of claim 7, wherein the heatsink members are aluminum castings.

12. The process of claim 7, wherein the weld joint is produced by friction stir welding.

13. A heatsink for conducting heat away from an electronic module, comprising:
at least a first heatsink member joined to at least a second heatsink member by a weld joint to define a heatsink having an internal plenum, the weld joint having a grain structure that is finer than the grain structure of a thermal weld joint; and
at least one electronic module in thermal contact with the heatsink.

14. The heatsink of claim 13, wherein the heatsink members are comprised of a material having a thermal conductivity of at least 10 watts per meter per degree Kelvin.

15. The heatsink of claim 13, wherein the heatsink members are comprised of a material having a thermal conductivity of at least 100 watts per meter per degree Kelvin.

16. The heatsink of claim 13, wherein the heatsink members are comprised of aluminum.

17. The heatsink of claim 13, wherein the heatsink members are aluminum castings.

18. The heatsink of claim 13, wherein the weld joint is produced by friction stir welding.
